# FASCICULE DE BREVET EUROPEEN

(11) **EP 4 479 574 B1**
(45) Date de publication et mention de la délivrance du brevet: **31.12.2025**
(21) Numéro de dépôt: 23708846.3
(22) Date de dépôt: 16.02.2023
(51) Int. Cl.: C23C 16/04, C23C 16/44, C23C 16/455, C23C 16/458, C04B 35/565, C04B 35/80, C04B 35/83, F16D 65/12, F16D 69/02

(54) **PROCÉDÉ DE DENSIFICATION CVI AVEC OUTILLAGE DE PLATEAUX MULTIPILES POUR FLUX SEMI-FORCE**
VERDICHTUNGSVERFAHREN FÜR CHEMISCHE DAMPFINFILTRATION MIT EINEM WERKZEUG VON MULTIPILE-PLATTEN FÜR HALBVERSTÄRKTEN FLUSS
CVI DENSIFICATION METHOD USING A TOOLING OF MULTI-PILE PLATES FOR SEMI-FORCED FLOW

(30) Priorité: 16.02.2022 FR 2201359
(43) Date de publication de la demande: 25.12.2024
(73) Titulaire: Safran Landing Systems, 78140 Vélizy-Villacoublay (FR)
(72) Inventeur: BOUCHARD, Eric, 77550 Moissy-Cramayel (FR)
(74) Mandataire: Cabinet Beau de Loménie
(86) Numéro de dépôt international: PCT/FR2023/050206
(87) Numéro de publication internationale: WO 2023/156737

(56) Documents cités:
- FR-A1- 2 754 813
- FR-A1- 3 084 892
- US-A1- 2005 178 327
- US-A1- 2017 247 793

## Description

### Domaine Technique

L'invention concerne la réalisation de pièces en matériau composite comprenant un substrat annulaire poreux densifiées par infiltration chimique en phase gazeuse (CVI), et plus particulièrement la réalisation de pièces munies d'un passage central. L'invention est applicable notamment, mais non exclusivement à la réalisation de disques de frein annulaires ou de divergents de tuyères de moteurs de fusée en matériau composite thermostructural.

### Technique antérieure

Les matériaux composites thermostructuraux sont remarquables par leurs propriétés mécaniques élevées et leur capacité à conserver ces propriétés à haute température. Des exemples typiques de matériaux composites thermostructuraux sont les composites carbone-carbone (C-C) comprenant un substrat poreux de renfort en fibres de carbone densifié par une matrice en carbone et les composites à matrice céramique (CMC) comprenant un substrat poreux de renfort en fibres réfractaires (par exemple en carbone ou céramique) densifié par une matrice céramique (par exemple en carbure de silicium).

Les matériaux composites C-C sont communément utilisés pour la réalisation de disques de frein d'aéronefs, cela en raison de leurs caractéristiques tribologiques à hautes énergies, leur non-fragilité, leurs caractéristiques thermiques (conductivité et capacité calorique) et leur densité.

La densification de substrats poreux par infiltration chimique en phase vapeur (CVI) consiste à placer les préformes annulaires dans une chambre de réaction d'une installation d'infiltration et à admettre dans la chambre une phase gazeuse dont un ou plusieurs constituants forment un précurseur du matériau de la matrice à déposer au sein des substrats afin d'assurer leur densification. Les conditions d'infiltration, notamment la composition et le débit de la phase gazeuse, et la température et la pression dans la chambre, sont choisies pour permettre une diffusion de la phase gazeuse au sein de la porosité interne accessible des substrats afin que le matériau désiré y soit déposé par décomposition d'un constituant de la phase gazeuse ou par réaction entre plusieurs constituants de celle-ci. Le document FR 2 834 713 décrit un tel procédé et une installation pour sa mise en œuvre.

Les conditions d'infiltration chimique en phase vapeur du carbone pyrolytique, ou pyrocarbone, sont connues depuis longtemps de l'homme de l'art. Le précurseur du carbone est un alcane, un alkyle ou un alcène, généralement du propane, du méthane ou un mélange des deux. L'infiltration est réalisée à une température d'environ 1000 ° C sous une pression par exemple d'erviron 1 kPa.

La phase gazeuse contenant le ou les précurseurs de matériau à déposer au sein des préformes est admise à une extrémité longitudinale de l'enceinte réactionnelle, tandis que les gaz résiduels sont évacués à l'extrémité opposée d'où ils sont extraits par des moyens de pompage.

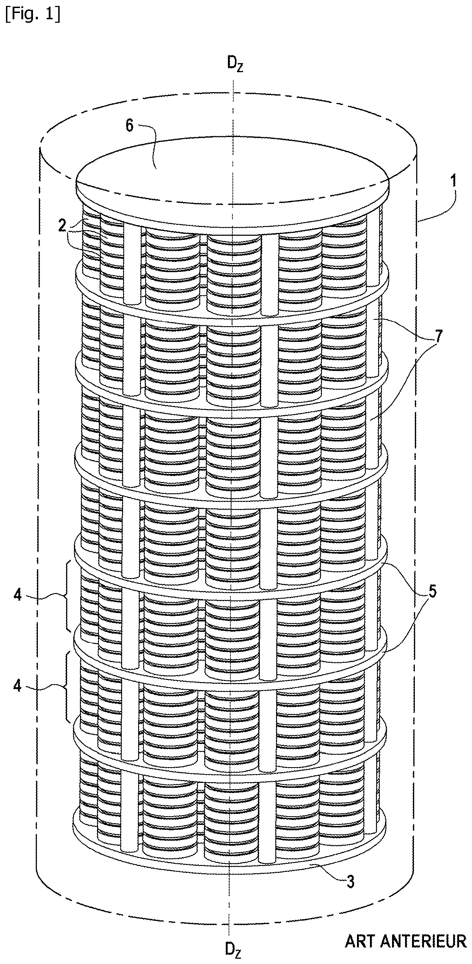

Lorsque l'on souhaite densifier un nombre important de piles de substrats, on utilise généralement une installation de grande taille. Un exemple connu de chargement de disques pouvant être utilisé dans une enceinte réactionnelle appelée communément « four de densification » est illustré sur la figure 1.

L'enceinte 1 est cylindrique autour d'un axe X. Le chargement comprend une pluralité de piles de substrats annulaires poreux 2 portées par un même plateau support inférieur 3. Chaque pile s'étend sous forme d'une colonne et est formée de plusieurs sections 4 de piles superposées et séparées par des plateaux supports intermédiaires 5 communs à toutes les piles. Les plateaux 3 et 5 comprennent des ouvertures alignées avec des passages centraux des substrats 2 afin de faire circuler dans chaque pile une phase gazeuse réactive qui traversera ensuite les substrats 2 pour les densifier. Un couvercle suscepteur forme un plateau supérieur 6 qui surmonte le chargement et ferme le volume interne de chaque pile (R1). Les plateaux supports intermédiaires 5 sont maintenus à l'aide de chandelles verticales 7.

L'organisation d'un atelier de traitement à hautes températures associant des moyens industriels de CVI, mais également de carbonisation ou de traitement thermique de préformes annulaires et de traitement thermiques sur ébauches partiellement ou totalement densifiées est faite autour de plateaux composés d'une à plusieurs piles, typiquement de 8 à 19 piles, suivant la taille des pièces et la taille des fours. Ces plateaux sont déplacés par des ponts roulants avec des élingues. Ils sont également stockés dans des racks ou dans des transstockeurs, qui sont amenés aux différents postes de travail (chargement des fours, contrôle densité, etc.).

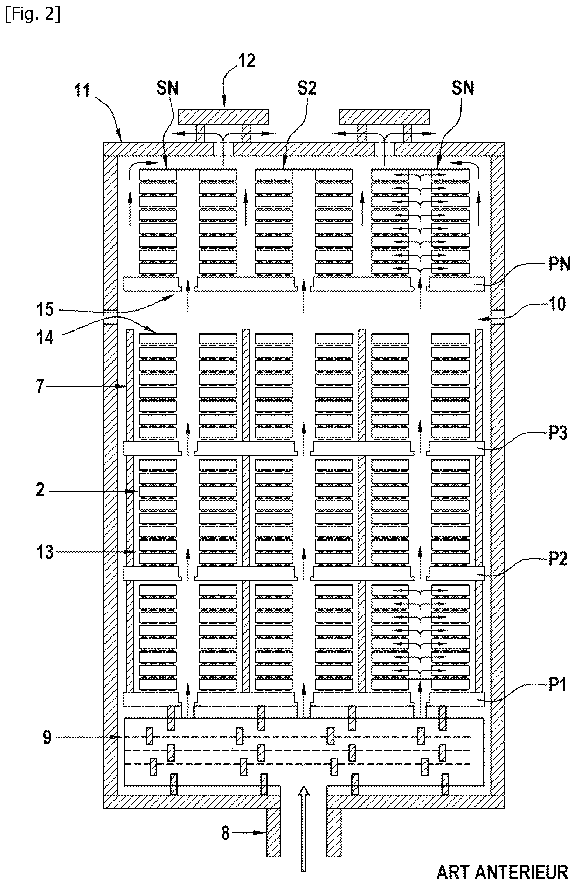

La figure 1 est une représentation de la zone chaude d'un chargement en flux dirigé. Comme cela est détaillé sur la figure 2 qui représente une vue en coupe du four de densification de la figure 1, cette zone chaude comprend, depuis sa base jusqu'à son sommet : une arrivée du mélange gazeux réactionnel 8, puis une zone de préchauffage 9 qui permet d'accroitre la température des gaz jusqu'à la température de densification, et enfin la zone la zone de chargement 10. En haut du four, au niveau du couvercle suscepteur 11, des cheminées 12 sont installées dans le couvercle 11, par lesquelles les gaz effluents issus de la réaction de dépôt sont évacués.

Le chargement est constitué d'un nombre N₁ de plateaux, référencés P1 à PN, pouvant supporter chacun un nombre de piles N₂ de substrats annulaires poreux 2, les piles étant référencées S1 à SN. Le nombre de plateaux et le nombre de piles sont liés aux dimensions du four et à celles des disques, c'est-à-dire des substrats annulaires poreux 2.

Sur chaque plateau se trouvent des piles de disques 2 séparés par des cales 13, chaque pile se terminant à son sommet par un disque de couverture 14 qui limite les fuites. A la base de chaque pile se trouve une virole 15 reposant sur le disque de couverture 14 de la pile inférieure. Cette virole 15 permet en coulissant de compenser les différences de hauteur entre piles. Enfin des chandelles 7 sont installées entre les piles S1 à SN qui servent à reprendre la masse des plateaux supérieurs P2 à PN.

Les gaz à l'issue de la zone de préchauffage 9 entrent dans chacune des colonnes constituées par les piles S1 à SN de disques 2. Le gaz passe de l'intérieur à l'extérieur des colonnes de disques, par les fuites constituées par les porosités de chaque préforme 2, le jeu entre les disques 2 crée par les cales 13, et par les passages entre les plateaux 3 et 5 (P1 à PN), à l'endroit des jeux de coulissement de la virole, la virole 15 laissant fuir les gaz de par son coulissement.

Il est connu du document FR 2 821 859 un procédé de densification par infiltration chimique en phase vapeur de substrats poreux utilisant notamment un flux semi forcé. Pour adapter le flux semi forcé tel que décrit dans ce document, les fuites entre les disques doivent être contrôlées et les fuites au passage entre plateaux doivent être contrôlées également. Ce dernier point est le plus difficile car les piles de disques ne sont pas de même hauteur. Et en l'absence d'un excellent contrôle de cette étanchéité au sommet de chaque pile, la différence de pression nécessaire pour forcer le gaz à aller dans les porosités des disques 2 ne peut pas être obtenue. Il est également connu du brevet FR 3 084 892 de remplacer les chandelles par des distributeurs de gaz, qui permettent d'assurer simultanément les fonctions de reprise de la charge (fonction auparavant assurée par les chandelles), de guidage des gaz (froids), ce qui évite le refroidissement des disques, et de distribution des gaz au niveau des

Un procédé de densification par CVI à gradient de pression de substrats annulaires poreux présentant un passage central est également connu du document US 2005/178327 A1.

### Exposé de l'invention

L'invention a pour but de fournir une solution technique pour la mise en œuvre d'un procédé de densification à gradient de pression qui permet d'améliorer la distribution du gaz réactif à l'intérieur d'une zone de chargement d'un four de densification et, d'une façon générale, de réduire les gradients de densification entre les substrats situés en des emplacements différents de la zone de chargement, et ce sans affecter la capacité de chargement du four, voire même en l'augmentant.

Un objet de l'invention propose un procédé de densification par infiltration chimique en phase gazeuse à gradient de pression de substrats annulaires poreux présentant un passage central, tel que défini dans les revendications 1-13.

Selon une caractéristique générale de l'invention, pour chaque second module unitaire surmonté d'un premier module unitaire, chaque empilement comprend au moins un anneau de couverture en appui sur le sommet de l'empilement de substrats annulaires poreux via une cale annulaire et un anneau d'étanchéité disposé autour de la cale annulaire dans un plan perpendiculaire à la direction dans laquelle les substrats annulaires poreux sont empilés, et un joint annulaire déformable disposé entre l'au moins un anneau de couverture et le plateau support dudit premier module unitaire.

Ledit au moins un anneau de couverture forme un couvercle en appui sur le sommet de l'empilement via une cale annulaire. Le couvercle d'un empilement et le joint annulaire associé ont pour fonction de fermer de manière étanche un empilement et ainsi permettre de réduire les fuites de gaz. Le couvercle et le joint annulaire déformable permettent ainsi de renforcer l'étanchéité entre le plateau support du module unitaire supérieur et le couvercle.

En outre, dans le cas où un empilement serait moins haut qu'un ou plusieurs autres empilements d'un même module unitaire l'empilement en question peut comprendre plusieurs couvercles superposés pour pallier le déficit de hauteur.

Les cales permettent de maintenir un espace entre les substrats annulaires poreux et ainsi d'augmenter la surface entrant directement en contact avec du gaz. En outre, les anneaux d'étanchéité ainsi disposés entre les substrats annulaires permettent d'éviter les fuites radiales entre les substrats annulaires poreux, et ainsi maximiser la quantité de gaz traversant les substrats annulaires poreux. Les anneaux d'étanchéité sont de préférence disposés au niveau de la périphérie radialement externe des substrats annulaires poreux. Les anneaux d'étanchéité sont par exemple réalisés en Inconel.

Dans un exemple de réalisation, chaque joint annulaire déformable peut être agencé pour pouvoir subir une déformation selon la direction dans laquelle sont empilés les substrats annulaires poreux supérieure ou égale à une épaisseur de l'anneau de couverture, par exemple de 3 mm. Par ailleurs, chaque joint annulaire déformable présente par exemple une résistance thermique à une température de 1100 °C.

Le joint annulaire déformable peut être réalisé en graphite expansé ou en tresses ou cordes en fibres de carbone ou en fibres céramiques.

Dans un exemple de réalisation, chaque empilement peut comprendre au moins trois jambes s'étendant, selon la direction dans laquelle les substrats annulaires poreux sont empilés, depuis le disque de couverture vers le plateau support sur lequel est disposé l'empilement.

Idéalement, les joints sont dans un matériau plus déformable que les substrats annulaires poreux des empilements. Les trois jambes suspendues au couvercle permettent de parer à l'éventualité contraire : la déformation des substrats annulaires poreux est ainsi limitée par les trois jambes suspendues à partir du couvercle et qui forment un système de reprise de charge.

Avantageusement, chaque module unitaire peut comprendre, pour chaque empilement, un tube d'injection monté sur l'ouverture d'admission de gaz et s'étendant dans le volume interne de l'empilement entre une première extrémité de tube reliée au plateau support et une deuxième extrémité de tube qui est libre, le tube d'injection comprenant en outre des orifices d'injection de gaz débouchant dans le volume interne, chaque ouverture d'admission de gaz du plateau support d'un premier module unitaire monté sur un second module unitaire communiquant avec une deuxième extrémité d'un des tubes d'injection du second module unitaire de façon à permettre la circulation d'un gaz entre les modules unitaires.

Dans un exemple de réalisation, chaque plateau support peut comprendre une première face sur laquelle sont disposés les empilements et une seconde face opposée à la première face, chaque ouverture d'admission de gaz peut comprendre une forme tronconique avec un premier diamètre formé dans la seconde face du support et un second diamètre plus petit que le premier diamètre et formé dans la première face ou entre la première et la seconde face du plateau support, et la deuxième extrémité de chaque tube d'injection peut comprendre une forme tronconique complémentaire coopérant avec la forme tronconique d'une ouverture d'admission de gaz.

Les tubes d'injection forment ainsi des outils de centrage mâles et les ouvertures d'admission de gaz des outils de centrage femelles qui coopèrent ensemble pour assurer un bon centrage des modules unitaires les uns avec les autres.

Avantageusement, le procédé peut comprendre en outre une étape d'alignement étanche des modules unitaires de la pile, la deuxième extrémité de chaque tube d'injection étant insérée dans une ouverture d'admission de gaz du premier module unitaire, et le premier module unitaire comportant en outre, pour chaque tube d'injection, un joint annulaire de tube disposé entre la deuxième extrémité du tube d'injection du deuxième module unitaire et l'ouverture d'admission de gaz du premier module unitaire avec laquelle il coopère.

L'invention permet ainsi d'améliorer la répartition du gaz dans l'enceinte du four et de faciliter l'installation du four de densification. L'étanchéité entre deux modules, assurée par le joint annulaire de tube est obtenue par la seule force du poids, lors du chargement du four.

Le joint annulaire de tube peut être réalisé en graphite expansé ou en tresses ou cordes en fibres de carbone ou en fibres céramiques.

Dans un exemple de réalisation, chaque tube d'injection peut comprendre une portion tubulaire principale formant un épaulement avec la forme tronconique de la deuxième extrémité, l'épaulement permettant au joint annulaire de tube de se déformer dans un plan perpendiculaire à la direction selon laquelle les substrats annulaires poreux sont empilés.

Dans un exemple de réalisation, le joint annulaire de tube est de préférence de forme tronconique pour s'adapter aux formes de la deuxième extrémité des tubes d'injection et de l'ouverture d'admission de gaz.

Dans un exemple de réalisation, chaque plateau support peut comprendre, pour chaque tube d'injection, un anneau de centrage centré autour d'une ouverture d'admission de gaz et conformé pour accueillir un tube d'injection.

L'anneau de centrage permet ainsi de faciliter et d'optimiser la pose des tubes d'injection sur les plateaux support.

Dans un exemple de réalisation, chaque substrat annulaire poreux peut comprendre du carbone.

Dans un exemple de réalisation, chaque substrat annulaire poreux peut constituer une préforme fibreuse de disque de frein.

Dans un exemple de réalisation, chaque premier substrat annulaire poreux est en appui sur un deuxième substrat annulaire poreux, ou en appui sur le plateau support, par l'intermédiaire d'une cale annulaire et d'un anneau d'étanchéité entourant la cale annulaire, l'anneau d'étanchéité assurant l'étanchéité radiale entre le premier substrat annulaire poreux et le deuxième substrat annulaire poreux ou entre le premier substrat annulaire poreux et ledit plateau support.

Avantageusement, chaque module unitaire surmonté d'un autre module unitaire peut comprendre une pluralité de chandelles s'étendant entre le plateau support dudit module unitaire et le plateau support dudit module unitaire qui le surmonte pour reprendre la masse dudit au moins un module unitaire supérieur.

De préférence, chaque chandelle possède une hauteur inférieure à la hauteur des empilements de substrats annulaires poreux.

En particulier, chaque chandelle peut présenter une hauteur inférieure à la somme, dans chaque empilement, de l'épaisseur du joint annulaire déformable, de l'épaisseur de l'anneau de couverture, de l'épaisseur de l'anneau d'étanchéité ou des anneaux d'étanchéité, et des épaisseurs des substrats annulaires poreux dudit empilement. Les épaisseurs du joint annulaire déformable et des anneaux d'étanchéité sont à considérer hors compression. Lorsqu'un empilement comprend plusieurs anneaux de couverture, l'épaisseur à prendre en compte est alors celle de l'ensemble des anneaux de couverture.

Par ailleurs, chaque chandelle présente de préférence une hauteur supérieure à la somme, dans chaque empilement, de l'épaisseur de l'anneau de couverture et des épaisseurs des substrats annulaires poreux dudit empilement. Lorsqu'un empilement comprend plusieurs anneaux de couverture, l'épaisseur à prendre en compte est alors celle de l'ensemble des anneaux de couverture.

Dans le présent document, la hauteur s'entend comme la dimension selon laquelle les substrats annulaires poreux sont empilés, et correspond en général à la direction verticale.

### Brève description des dessins

[Fig. 1] La figure 1, déjà décrite, montre de façon très schématique un exemple de chargement de substrats annulaires poreux selon l'art antérieur.
[Fig. 2] La figure 2, déjà décrite, présente une vue en coupe du four de densification de la figure 1.
[Fig. 3] La figure 3 illustre schématiquement une vue en coupe d'un exemple d'empilement de substrats annulaires poreux selon l'invention.
[Fig. 4] La figure 4 présente schématiquement une vue en coupe d'un exemple de module unitaire selon l'invention.
[Fig. 5] La figure 5 présente une vue en coupe d'un premier exemple de joint annulaire de tube.
[Fig. 6] La figure 6 présente schématiquement une vue en coupe d'un second exemple de joint annulaire de tube.
[Fig. 7] La figure 7 présente schématiquement une vue en coupe d'une variante de réalisation d'un tube d'injection selon l'invention.
[Fig. 8] La figure 8 présente schématiquement une vue en coupe d'un exemple de module unitaire selon un autre mode de réalisation de l'invention.

### Description des modes de réalisation

Un procédé de densification par infiltration chimique en phase gazeuse selon l'invention comprend tout d'abord une étape durant laquelle on fournit une pluralité d'empilement de substrats annulaires poreux destinés à être traités par infiltration chimique en phase gazeuse.

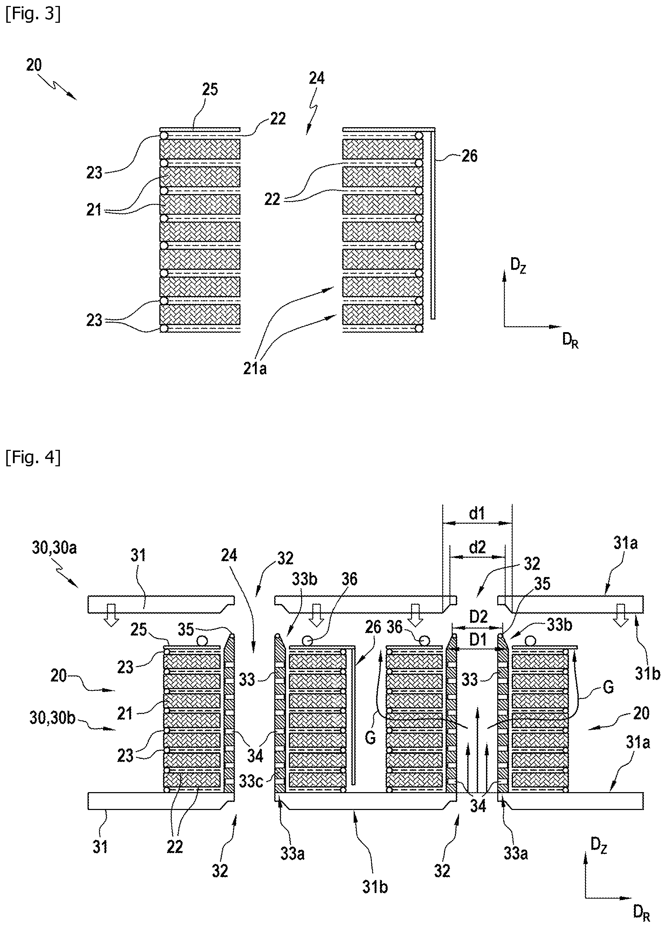

Sur la figure 3 est illustrée une vue en coupe d'un exemple d'empilement 20 de substrats annulaires poreux 21. Les substrats annulaires poreux 21 possèdent une symétrie cylindrique et sont empilés selon une première direction D_{Z}. Chaque substrat annulaire poreux 21 s'étend principalement dans un plan perpendiculaire à la première direction D_{Z}. Le plan de coupe de l'illustration de la figure 3 comprend la première direction D_{Z} et une seconde direction D_{R} perpendiculaire à la première direction D_{Z}. La première direction D_{Z} est confondue avec l'axe de symétrie de révolution des substrats annulaires poreux 21, et la seconde direction D_{R} correspond à une direction radiale.

Chaque substrat annulaire poreux 21 de l'empilement 20 présente ainsi une forme d'anneau avec un passage central 21a. Chaque substrat annulaire poreux 21 est disposé sur une cale annulaire 22 dont le diamètre radial extérieur est plus petit que le diamètre radial extérieur des substrats annulaires poreux 21, les diamètres des orifices des cales 22 et des substrats annulaires poreux 21 étant égaux.

Chaque cale 22 est entourée d'un anneau d'étanchéité 23 dans le plan perpendiculaire à la première direction D_{Z}. Chaque substrat annulaire poreux 21 repose ainsi sur une cale annulaire 22 et sur un anneau d'étanchéité 23.

L'empilement alternatif des substrats annulaires poreux 21 et des cales 22 forme, au centre de l'empilement 20, un volume interne 24 de l'empilement 20.

En outre, l'empilement 20 est fermé en son sommet par un couvercle 25 annulaire. Le couvercle 25 est posé sur l'empilement via une cale 22 annulaire et un anneau d'étanchéité 23.

Le procédé de densification par infiltration chimique en phase gazeuse selon l'invention comprend ensuite une étape durant laquelle on fournit une pluralité de modules unitaires 30.

Sur la figure 4 est représentée schématiquement une vue en coupe d'un module unitaire 30 selon l'invention.

Chaque module unitaire 30 comprend un plateau support 31 et plusieurs empilements 20 de substrats annulaires poreux 21 disposés sur le plateau support 30. Pour chaque empilement 20, le plateau support 31 comporte une ouverture 32 d'admission de gaz et un tube d'injection 33 monté sur l'ouverture 32 d'admission de gaz et s'étendant dans le volume interne 24 d'un empilement 20 entre une première extrémité de tube 33a reliée au plateau support 31 et une deuxième extrémité de tube 33b qui est libre.

Le tube d'injection 33 comprend en outre des orifices 34 d'injection de gaz débouchant dans le volume interne 24.

Le procédé de densification par infiltration chimique en phase gazeuse selon l'invention comprend ensuite une étape durant laquelle on forme, dans l'enceinte d'un four de densification, une pile de modules unitaires 30 superposés les uns sur les autres selon la première direction D_{Z}.

Sur la figure 4 est représenté le plateau support 31 d'un premier module unitaire 30a sur le point d'être superposé sur un second module unitaire 30b.

L'étape de formation de la pile de modules unitaires 30 comprend en outre une étape d'alignement étanche des modules unitaires 30 de la pile. Comme cela est illustré sur la figure 4, pour réaliser l'alignement, la deuxième extrémité 33b de chaque tube d'injection 33 du second module unitaire 30b est insérée dans une ouverture 32 d'admission de gaz du premier module unitaire 30a.

Pour étanchéifier la jonction entre les tubes d'injection 33 du second module unitaire 30b et les ouvertures 32 d'admission de gaz du premier module unitaire 30a, le second module unitaire 30a comporte en outre, pour chaque tube d'injection 33, un joint annulaire 35 disposé entre la deuxième extrémité 33b du tube d'injection 33 du second module unitaire 30b et l'ouverture 32 d'admission de gaz du premier module unitaire 30a avec laquelle il coopère.

Plus particulièrement, chaque plateau support 31 comprend une première face 31a sur laquelle sont disposés les empilements 20 et une seconde face 31b opposée à la première face 31a. Chaque ouverture 32 d'admission de gaz comprend une forme tronconique avec un premier diamètre d1 formé dans la seconde face 31b du plateau support 31 et un second diamètre d2 plus petit que le premier diamètre d1 et formé entre la première face 31a et la seconde face 31b du plateau support 31.

La deuxième extrémité 33b de chaque tube d'injection 33 comprend une forme tronconique complémentaire de la forme tronconique d'une ouverture 32 d'admission de gaz pour que les deux formes tronconiques coopèrent ensemble. La forme tronconique complémentaire de la deuxième extrémité 33b du tube d'injection 33 comprend un premier diamètre D1 plus grand qu'un second diamètre D2, le second diamètre D2 étant mesuré sur une extrémité distale libre tandis que le premier diamètre D1 est mesuré sur une extrémité proximale couplée au reste du tube d'injection 33 et notamment à une portion principale 33c.

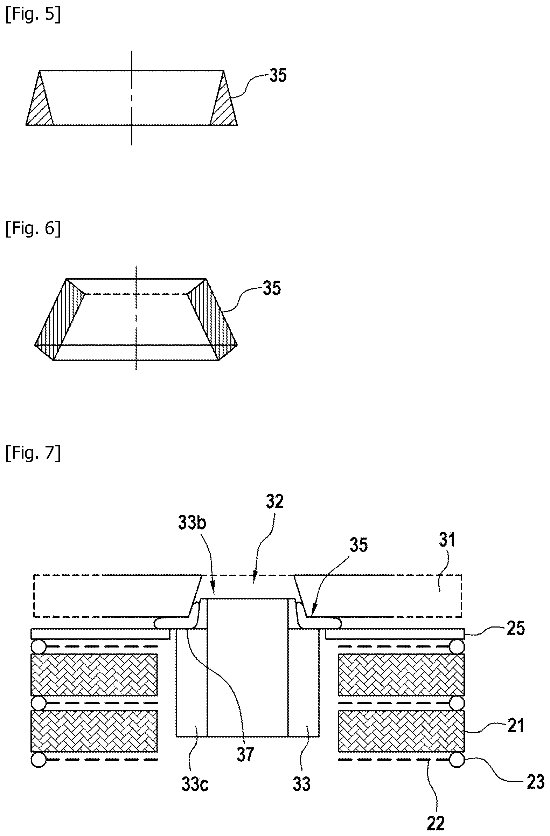

Sur les figures 5 et 6 sont illustrés deux exemples de joint annulaire 35 monté à l'interface entre la deuxième extrémité 33b du tube d'injection 33 du second module unitaire 30b et l'ouverture 32 d'admission de gaz du premier module unitaire 30a.

La figure 5 présente une vue en coupe d'un joint annulaire ayant une extrémité effilée, et la figure 6 présente une vue en coupe d'un joint annulaire ayant une section en parallélogramme.

Comme cela est illustré sur la figure 4, pour améliorer l'étanchéité de la pile de modules unitaires 30, plus particulièrement pour empêcher les fuites depuis les espaces annulaires entre les tube d'injection 33 et les substrats annulaires poreux 21 vers l'extérieur des empilements 20, lorsque deux modules unitaires 30 sont empilés l'un sur l'autre, le module unitaire inférieur, ici le second module unitaire 30b, comprend, pour chaque empilement 20, un joint annulaire déformable 36 disposé entre le couvercle 25 de l'empilement 20 et le plateau support 31 du module unitaire supérieur, ici le premier module unitaire 30a.

En outre, comme cela est illustré sur les figures 3 et 4, l'empilement 20 comprend en outre trois jambes (une seule par empilement est visible sur ces figures 3 et 4). Chaque jambe 26 s'étend, selon la direction Z dans laquelle les substrats annulaires poreux 21 sont empilés, depuis le couvercle 25 annulaire vers le plateau support 31 sur lequel est disposé l'empilement 20.

Comme cela est illustré sur la figure 7 qui représente un exemple de variante de réalisation d'un tube d'injection selon l'invention, chaque tube d'injection 33 peut comprendre une portion tubulaire principale 33c formant un épaulement 37 avec la forme tronconique de la deuxième extrémité 33b. L'épaulement 37 permet au joint annulaire 35 de se déformer dans un plan perpendiculaire à la première direction D_{Z} selon laquelle les substrats annulaires poreux 21 sont empilés.

Le procédé de densification par infiltration chimique en phase gazeuse selon l'invention comprend ensuite une étape durant laquelle on injecte dans le volume interne 24 de chaque empilement 20 de substrats annulaires poreux 21 une phase gazeuse comprenant un précurseur gazeux d'un matériau de matrice à déposer au sein de la porosité des substrats 21. L'injection du gaz est représentée sur la figure 4 par les flèches G.

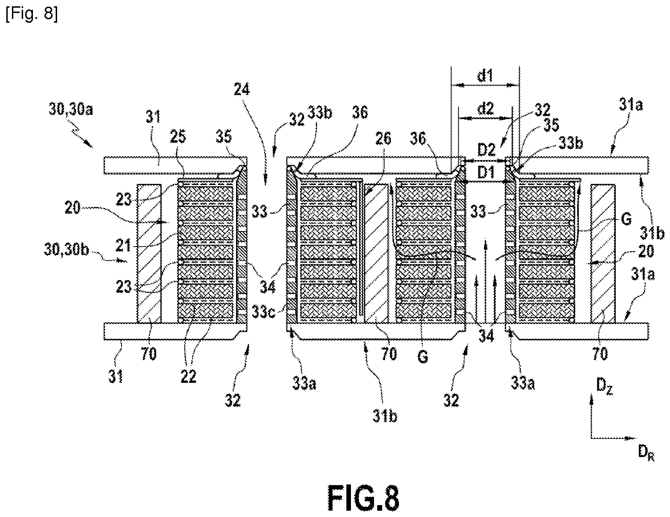

Dans le mode de réalisation illustré sur la figure 8, chaque module unitaire 30 surmonté d'un autre module unitaire 30 comprend en outre une pluralité de chandelles 70 s'étendant entre le plateau support 31 du module unitaire 30 et le plateau support 31 du module unitaire 30 qui le surmonte pour reprendre la masse du (ou des) module(s) unitaire(s) 30 supérieur(s).

Chaque chandelle 70 possède une hauteur inférieure à la hauteur des empilements 20 de substrats annulaires poreux 21. Plus précisément, chaque chandelle 70 présente une hauteur inférieure à la somme, dans chaque empilement 20, de l'épaisseur du joint annulaire déformable 36, de l'épaisseur de l'anneau de couverture 25, des épaisseurs des anneaux d'étanchéité 23, et des épaisseurs des substrats annulaires poreux 21 dudit empilement.

## Revendications

1. Procédé de densification par infiltration chimique en phase gazeuse à gradient de pression de substrats annulaires poreux (21) présentant un passage central (21a), le procédé comprenant au moins les étapes suivantes :
- fournir une pluralité d'empilements (20) de substrats annulaires poreux (21), chaque empilement (20) comportant un volume interne (24) formé par les passages centraux (21a) des substrats (21) empilés,
- fournir une pluralité de modules unitaires (30), chaque module unitaire (30) comprenant un plateau support (31) et des empilements (20) de substrats annulaires poreux (21) disposés sur le plateau support (31), le plateau support (31) comportant, pour chaque empilement (20), une ouverture d'admission de gaz (32) débouchant dans le volume interne (24),
- former, dans l'enceinte d'un four de densification, une pile de modules unitaires (30), chaque ouverture d'admission (32) de gaz du plateau support (31) d'un premier module unitaire (30a) monté sur un second module unitaire (30b) communiquant avec le volume interne (24) d'un des empilements (20) du second module unitaire (30b) de façon à permettre la circulation d'un gaz entre les modules unitaires (30), et
- injecter dans le volume interne (24) de chaque empilement (20) de substrats annulaires poreux (21) une phase gazeuse comprenant un précurseur gazeux d'un matériau de matrice à déposer au sein de la porosité des substrats (21),
**caractérisé en ce que**, pour chaque second module unitaire (30b) surmonté d'un premier module unitaire (30a), chaque empilement (20) comprend au moins un anneau de couverture (25) en appui sur le sommet de l'empilement de substrats annulaires poreux (21) via une cale (22) annulaire et un anneau d'étanchéité (23) disposé autour de la cale (22) annulaire dans un plan perpendiculaire à la direction (D_{Z}) dans laquelle les substrats annulaires poreux (21) sont empilés, et un joint annulaire déformable (36) disposé entre l'au moins un anneau de couverture (25) et le plateau support (31) dudit premier module unitaire (30a).

2. Procédé selon la revendication 1, dans lequel chaque joint annulaire déformable (36) est agencé pour pouvoir subir une déformation, selon la direction (D_{Z}) dans laquelle les substrats annulaires poreux (21) sont empilés, supérieure ou égale à une épaisseur d'un anneau de couverture (25).

3. Procédé selon l'une des revendications 1 et 2, dans lequel chaque empilement (20) comprend au moins trois jambes (26) s'étendant, selon la direction (D_{Z}) dans laquelle les substrats annulaires poreux (21) sont empilés, depuis l'anneau de couverture (25) vers le plateau support (31) sur lequel est disposé l'empilement (20).

4. Procédé selon l'une des revendications 1 à 3, dans lequel le plateau support (31) de chaque module unitaire (30) comporte, pour chaque empilement (20), un tube d'injection (33) monté sur l'ouverture d'admission de gaz (32) et s'étendant dans le volume interne (24) de l'empilement (20) entre une première extrémité de tube (33a) reliée au plateau support (31) et une deuxième extrémité de tube (33b) qui est libre, le tube d'injection (33) comprenant en outre des orifices d'injection de gaz (34) débouchant dans le volume interne (24), chaque ouverture d'admission (32) de gaz du plateau support (31) d'un premier module unitaire (30a) monté sur un second module unitaire (30b) communiquant avec une deuxième extrémité (33b) d'un des tubes d'injection (33) du second module unitaire (30b) de façon à permettre la circulation d'un gaz entre les modules unitaires (30).

5. Procédé selon la revendication 4, dans lequel chaque plateau support (31) comprend une première face (31a) sur laquelle sont disposés les empilements (20) et une seconde face (31b) opposée à la première face (31a), chaque ouverture d'admission de gaz (32) comprend une forme tronconique avec un premier diamètre (d1) formé dans la seconde face (31b) du plateau support (31) et un second diamètre (d2) plus petit que le premier diamètre (d1) et formé dans la première face (31a) ou entre la première face (31a) et la seconde face (31b) du plateau support (31), et la deuxième extrémité (33b) de chaque tube d'injection (33) comprend une forme tronconique complémentaire coopérant avec la forme tronconique d'une ouverture d'admission de gaz (32).

6. Procédé selon l'une des revendications 4 ou 5, comprenant en outre une étape d'alignement étanche des modules unitaires (30) de la pile, la deuxième extrémité (33b) de chaque tube d'injection (33) du second module unitaire (30b) étant insérée dans une ouverture (32) d'admission de gaz du premier module unitaire (30a), et le second module unitaire (30b) comportant en outre, pour chaque tube d'injection (33), un joint annulaire (35) disposé entre la deuxième extrémité (33b) du tube d'injection (33) du second module unitaire (30b) et l'ouverture (32) d'admission de gaz du premier module unitaire (30a) avec laquelle il coopère.

7. Procédé selon la revendication 6, dans lequel chaque tube d'injection (33) comprend une portion tubulaire principale (33c) formant un épaulement (37) avec la forme tronconique de la deuxième extrémité (33b), l'épaulement (37) permettant au joint annulaire (35) de se déformer dans un plan perpendiculaire à la direction (D_{Z}) selon laquelle les substrats annulaires poreux (21) sont empilés.

8. Procédé selon l'une des revendications 6 ou 7, dans lequel le joint annulaire (35) est de forme tronconique.

9. Procédé selon l'une des revendications 1 à 8, dans lequel chaque plateau support (31) comprend, pour chaque tube d'injection (33), un anneau de centrage centré autour d'une ouverture de gaz (32) et conformé pour accueillir un tube d'injection (33).

10. Procédé selon l'une des revendications 1 à 9, dans lequel chaque substrat annulaire poreux (21) comprend du carbone.

11. Procédé selon l'une des revendications 1 à 10, dans lequel chaque substrat annulaire poreux (21) constitue une préforme fibreuse de disque de frein.

12. Procédé selon l'une des revendications 1 à 11, dans lequel chaque module unitaire (30) surmonté d'un autre module unitaire (30) comprend une pluralité de chandelles (70) s'étendant entre le plateau support (31) dudit module unitaire (30) et le plateau support (31) dudit module unitaire (30) qui le surmonte pour reprendre la masse dudit au moins un module unitaire (30) supérieur.

13. Procédé selon la revendication 12, dans lequel chaque chandelle (70) possède une hauteur inférieure à la hauteur des empilements (20) de substrats annulaires poreux (21).

## Patentansprüche

1. Verfahren zur Verdichtung von ringförmigen porösen Substraten (21), die einen zentralen Durchgang (21a) aufweisen, durch chemische Druckgradient-Gasphasen-Infiltration, wobei das Verfahren zumindest die folgenden Schritte umfasst:
- Bereitstellen von mehreren Aufstapelungen (20) von ringförmigen porösen Substraten (21), wobei jede Aufstapelung (20) ein Innenvolumen (24) beinhaltet, das durch die zentralen Durchgänge (21a) der gestapelten Substrate (21) gebildet wird,
- Bereitstellen von mehreren Einheitsmodulen (30), wobei jedes Einheitsmodul (30) eine Stützplattform (31) und Aufstapelungen (20) von ringförmigen porösen Substraten (21) umfasst, die auf der Stützplattform (31) angeordnet sind, wobei die Stützplattform (31) für jede Aufstapelung (20) eine Gaseinlassöffnung (32) beinhaltet, die in das Innenvolumen (24) mündet,
- Bilden eines Stapels von Einheitsmodulen (30) in der Einhausung eines Verdichtungsofens, wobei jede Gaseinlassöffnung (32) der Stützplattform (31) eines ersten Einheitsmoduls (30a), das über einem zweiten Einheitsmodul (30b) montiert ist, mit dem Innenvolumen (24) eines der Aufstapelungen (20) des zweiten Einheitsmoduls (30b) auf solche Weise kommuniziert, dass die Zirkulation eines Gases zwischen den Einheitsmodulen (30) ermöglicht wird, und
- Injizieren einer Gasphase umfassend einen gasförmigen Vorläufer eines Matrixmaterials, das innerhalb der Porosität der Substrate (21) abgeschieden werden soll, in das Innenvolumen (24) einer jeden Aufstapelung (20) von ringförmigen porösen Substraten (21)
**dadurch gekennzeichnet, dass** für jedes zweite Einheitsmodul (30b), über welchem ein erstes Einheitsmodul (30a) montiert ist, jede Aufstapelung (20) zumindest einen Abdeckring (25), der über einen ringförmigen Keil (22) gegen den Scheitel der Aufstapelung von ringförmigen porösen Substraten (21) anliegt, und einen Dichtungsring (23), der um den ringförmigen Keil (22) herum in einer Ebene senkrecht zu der Richtung (D_{Z}) angeordnet ist, in welcher die ringförmigen porösen Substrate (21) gestapelt sind, und eine verformbare ringförmige Dichtung (36) umfasst, die zwischen dem zumindest einen Abdeckring (25) und der Stützplattform (31) des ersten Einheitsmoduls (30a) angeordnet ist.

2. Verfahren nach Anspruch 1, wobei jede verformbare ringförmige Dichtung (36) so angeordnet wird, dass sie eine Verformung gemäß der Richtung (D_{Z}), in welcher die ringförmigen porösen Substrate (21) gestapelt sind, erfahren kann, die größer als oder gleich einer Dicke eines Abdeckrings (25) ist.

3. Verfahren nach einem der Ansprüche 1 und 2, wobei jede Aufstapelung (20) zumindest drei Beine (26) umfasst, die sich gemäß der Richtung (D_{Z}), in welcher die ringförmigen porösen Substrate (21) gestapelt sind, von dem Abdeckring (25) zu der Stützplattform (31) hin erstreckt, auf welcher die Aufstapelung (20) angeordnet ist.

4. Verfahren nach einem der Ansprüche 1 bis 3, wobei die Stützplattform (31) eines jeden Einheitsmoduls (30) für jede Aufstapelung (20) ein Injektionsrohr (33) umfasst, das an der Gaseinlassöffnung (32) montiert ist und sich in dem Innenvolumen (24) der Aufstapelung (20) zwischen einem ersten Rohrende (33a), das mit der Stützplattform (31) verbunden ist, und einem zweiten Rohrende (33b) erstreckt, wobei das Injektionsrohr (33) ferner Gas-Injektionsöffnungen (34) umfasst, die in das Innenvolumen (24) münden, wobei jede Gaseinlassöffnung (32) der Stützplattform (31) eines ersten Einheitsmoduls (30a), das auf einem zweiten Einheitsmoduls (30b) montiert ist, auf solche Weise mit einem zweiten Ende (33b) eines der Injektionsrohre (33) des zweiten Einheitsmoduls (30b) kommuniziert, dass die Zirkulation eines Gases zwischen den Einheitsmodulen (30) ermöglicht wird.

5. Verfahren nach Anspruch 4, wobei jede Stützplattform (31) eine erste Seite (31a), auf welcher die Aufstapelungen (20) angeordnet sind, und eine zweite Seite (31b) umfasst, die der ersten Seite (31a) entgegengesetzt ist, wobei jede Gaseinlassöffnung (32) eine kegelstumpfförmige Form mit einem ersten Durchmesser (d1), der in der zweiten Seite (31b) der Stützplattform (31) gebildet ist, und einem zweiten Durchmesser (d2) umfasst, der kleiner ist als der erste Durchmesser (d1) und in der ersten Seite (31a) oder zwischen der ersten Seite (31a) und der zweiten Seite (31b) der Stützplattform (31) gebildet ist, und das zweite Ende (33b) eines jeden Injektionsrohrs (33) eine komplementäre kegelstumpfförmige Form umfasst, die mit der kegelstumpfförmigen Form einer Gaseinlassöffnung (32) zusammenwirkt.

6. Verfahren nach einem der Ansprüche 4 oder 5, umfassend ferner einen Schritt der dichten Ausrichtung von Einheitsmodulen (30) des Stapels, wobei das zweite Ende (33b) eines jeden Injektionsrohrs (33) des zweiten Einheitsmoduls (30b) in eine Gaseinlassöffnung (32) des ersten Einheitsmoduls (30a) eingeführt wird, und das zweite Einheitsmodul (30b) ferner für jedes Injektionsrohr (33) eine ringförmige Dichtung (35) beinhaltet, die zwischen dem zweiten Ende (33b) des Injektionsrohrs (33) des zweiten Einheitsmoduls (30b) und der Gaseinlassöffnung (32) des ersten Einheitsmoduls (30a), mit welchem es zusammenwirkt, angeordnet ist.

7. Verfahren nach Anspruch 6, wobei jedes Injektionsrohr (33) einen rohrförmigen Hauptabschnitt (33c) umfasst, der mit der kegelstumpfförmigen Form des zweiten Endes (33b) eine Schulter (37) ausbildet, wobei die Schulter (37) der ringförmigen Dichtung (35) ermöglicht, sich in einer Ebene senkrecht zu der Richtung (D_{Z}), gemäß welcher die ringförmigen porösen Substrate (21) gestapelt sind, zu verformen.

8. Verfahren nach einem der Ansprüche 6 oder 7, wobei die ringförmige Dichtung (35) eine kegelstumpfförmige Form aufweist.

9. Verfahren nach einem der Ansprüche 1 bis 8, wobei jede Stützplattform (31) für jedes Injektionsrohr (33) einen Zentrierring umfasst, der um eine Gaseinlassöffnung (32) zentriert und so geformt ist, das er ein Injektionsrohr (33) aufnehmen kann.

10. Verfahren nach einem der Ansprüche 1 bis 9, wobei jedes ringförmige poröse Substrat (21) Kohlenstoff umfasst.

11. Verfahren nach einem der Ansprüche 1 bis 10, wobei jedes ringförmige poröse Substrat (21) eine Faservorform einer Bremsscheibe bildet.

12. Verfahren nach einem der Ansprüche 1 bis 11, wobei jedes Einheitsmodul (30), über welchem ein weiteres Einheitsmodul (30) montiert ist, mehrere Stümpfe (70) umfasst, die sich zwischen der Stützplattform (31) des Einheitsmoduls (30) und der Stützplattform (31) des Einheitsmoduls (30), das über ihm montiert ist, erstrecken, um die Masse des zumindest einen darüberliegenden Einheitsmoduls (30) zu tragen.

13. Verfahren nach Anspruch 12, wobei jeder Stumpf (70) eine Höhe besitzt, die geringer als die Höhe der Aufstapelungen (20) von ringförmigen porösen Substraten (21) ist.

## Claims

1. A method for densification by pressure gradient chemical vapor infiltration of porous annular substrates (21) having a central passage (21a), the method comprising at least the following steps:
- providing a plurality of stacks (20) of porous annular substrates (21), each stack (20) comprising an internal volume (24) formed by the central passages (21a) of the stacked substrates (21),
- providing a plurality of individual modules (30), each individual module (30) comprising a support plate (31) and stacks (20) of porous annular substrates (21) disposed on the support plate (31), the support plate (31) comprising, for each stack (20), a gas inlet opening (32) emerging into the internal volume (24),
- forming, in the chamber of a densification furnace, a stack of individual modules (30), each gas inlet opening (32) of the support plate (31) of a first individual module (30a) mounted on a second individual module (30b) communicating with the internal volume (24) of one of the stacks (20) of the second individual module (30b) so as to allow a gas to flow between the individual modules (30), and
- injecting into the internal volume (24) of each stack (20) of porous annular substrates (21) a gas phase comprising a gaseous precursor of a matrix material to be deposited within the porosities of the substrates (21),
**characterized in that**, for each second individual module (30b) surmounted by a first individual module (30a), each stack (20) comprises at least one cover ring (25) supported on the top of the stack of porous annular substrates (21) via an annular spacer (22) and a sealing ring (23) disposed around the annular spacer (22) in a plane perpendicular to the direction (D_{Z}) in which the porous annular substrates (21) are stacked, and a deformable annular seal (36) is disposed between the at least one cover ring (25) and the support plate (31) of said first individual module (30a).

2. The method according to claim 1, wherein each deformable annular seal (36) is arranged to be capable of undergoing deformation, along the direction (D_{Z}) in which the porous annular substrates (21) are stacked, greater than or equal to a thickness of a cover ring (25).

3. The method according to one of claims 1 and 2, wherein each stack (20) comprises at least three legs (26) extending in the direction (D_{Z}) in which the porous annular substrates (21) are stacked, from the cover ring (25) to the support plate (31) on which the stack (20) is disposed.

4. The method according to any one of claims 1 to 3, wherein the support plate (31) of each individual module (30) comprises, for each stack (20), an injection tube (33) mounted on the gas inlet opening (32) and extending into the internal volume (24) of the stack (20) between a first tube end (33a) connected to the support plate (31) and a second tube end (33b) which is free, the injection tube (33) further comprising gas injection openings (34) emerging into the internal volume (24), each gas inlet opening (32) of the support plate (31) of a first individual module (30a) mounted on a second individual module (30b) communicating with a second end (33b) of one of the injection tubes (33) of the second individual module (30b) so as to allow a gas to flow between the individual modules (30).

5. The method according to claim 4, wherein each support plate (31) comprises a first face (31a) on which are disposed stacks (20) and a second face (31b) opposite the first face (31a), each gas inlet opening (32) comprises a frustoconical shape with a first diameter (d1) formed in the second face (31b) of the support (31) and a second diameter (d2) smaller than the first diameter (d1) and formed in the first face (31a) or between the first face (31a) and second face (31b) of the support plate (31), and the second end (33b) of each injection tube (33) comprises a complementary frustoconical shape cooperating with the frustoconical shape of the gas inlet opening (32).

6. The method according to claim 4 or 5, further comprising a sealed alignment step of the individual modules (30) of the stack, the second end (33b) of each injection tube (33) of the second individual module (30b) being inserted into a gas inlet opening (32) of the first individual module (30a), and the second individual module (30b) further comprising, for each injection tube (33), an annular tube seal (35) disposed between the second end (33b) of the injection tube (33) of the second individual module (30b) and the gas inlet opening (32) of the first individual module (30a) with which it cooperates.

7. The method according to claim 6, wherein each injection tube (33) comprises a main tubular portion (33c) forming a shoulder (37) with the frustoconical shape of the second end (33b), the shoulder (37) allowing the annular seal (35) to deform in a plane perpendicular to the direction (D_{Z}) along which the porous annular substrates (21) are stacked.

8. The method according to one of claims 6 to 7, wherein each annular seal (35) is frustoconical in shape.

9. The method according to any one of claims 1 to 8, wherein each support plate (31) comprises, for each injection tube (33), a centering ring centered around a gas opening (32) and shaped to receive an injection tube (33).

10. The method according to any one of claims 1 to 9, wherein each porous annular substrate (21) comprises carbon.

11. The method according to any one of claims 1 to 10, wherein each porous annular substrate (21) constitutes a fibrous brake disc preform.

12. The method according to any one of claims 1 to 11, wherein each individual module (30) surmounted by another individual module (30) comprises a plurality of rods (70) extending between the support plate (31) of said individual module (30) and the support plate (31) of said individual module (30) which surmounts it to take up the mass of said at least one upper individual module (30).

13. The method of claim 12, wherein each rod (70) has a height less than the height of the stacks (20) of porous annular substrates (21).
